(19) Europäisches Patentamt
European Patent Office
Office européen des brevets

(11) **EP 1 764 840 A1**

(12) **EUROPEAN PATENT APPLICATION**

(43) Date of publication:
**21.03.2007 Bulletin 2007/12**

(51) Int Cl.:
**H01L 33/00** (2006.01)      **H01S 5/343** (2006.01)

(21) Application number: **05020082.3**

(22) Date of filing: **15.09.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicant: **SuperNova Optoelectronics Corporation**
**Ping Cheng City, Taiwan**
**T'ao yuan (TW)**

(72) Inventor: **Mu-Jen, Lai**
**Ping Cheng City,**
**Taoyuan County (TW)**

(74) Representative: **Manasse, Uwe**
**Forrester & Boehmert,**
**Pettenkoferstrasse 20-22**
**80336 München (DE)**

(54) **Gallium nitride semiconductor light emitting device**

(57)      The present invention is a semiconductor structure for light emitting devices that can emit light with multiple wavelengths, in particular, in the blue to ultraviolet region of the electromagnetic spectrum. The structure comprises an active portion positioned between a p-type gallium nitride (GaN) layer and an n-type gallium nitride (GaN) layer. The active portion includes an MQW emitting light with long wavelength and an MQW emitting light with short wavelength. There is another group of strain induces thickness fluctuation layers (SITFL) positioned between the active portion and the n-type gallium nitride (GaN) layer. The semiconductor structure itself is based on a sapphire substrate. A low temperature buffer layer is positioned between the sapphire substrate and the n-type gallium nitride (GaN) layer. There is still another undoped gallium nitride (GaN) layer positioned between n-type gallium nitride (GaN) layer and the low temperature buffer layer. In addition, the SITFL is composed of multiple gallium nitride (GaN) layers doped with silicon (Si) element.

Fig. 1

EP 1 764 840 A1

## Description

### FIELD OF THE INVENTION

The present invention relates to a gallium nitride semiconductor light emitting device and, more particularly, to a gallium nitride semiconductor device emitting dual wavelengths spectrum, one is in violet portion, the other one is in blue portion of the electromagnetic spectrum.

### BACKGROUND OF THE INVENTION

The present invention provides semiconductor structures of light emitting devices, in particular made of Group III nitrides. The electromagnetic spectrum of the emitting light can be blue and violet dual wavelengths.

The emitting theory of the LED is according to the electroluminescence by the combination of the holes and electrons in the p-n junction of LED which is very different with the thermo luminescence of general bulbs. There is a small range of the frequency spectrum of light can be recognized by the retina of human eyes. The wavelength of the blue color we see in the natural world is about 460 nanometers corresponding to the bandgap voltage 2.7 eV wherein the bandgap is the energy gap between the energy states of a carrier. The wavelength of the red color is about 650 nanometers corresponding to the bandgap voltage 1.9 eV. The relationship between the wavelength and the bandgap energy is $\lambda = \dfrac{1240}{Eg}$ where $\lambda$ (nm) is the wavelength of light and $Eg$ (eV) is the bandgap energy of specific material.

The bandgap energy can be fine tuned by doping another material to increase the donors or acceptors to modify the bandgap from the original to that we expect. Increasing donors or acceptors can generate the probability of the combination of electrons and holes which means the bandgap is lower than the original energy level so that more electrons can across the energy barrier of bandgap energy and discharge with holes. A material with more donors is usually called n-type material and the one with more acceptors is p-type material. In the following paragraphs, several chemical elements are used as dopants or substrate materials in LEDs, like Group III and Group V, Group II and Group VI, or Group IV and Group IV. The most popular compound semiconductor devices are Group III and Group V including gallium arsenide GaAs, GaAlAs, GaAsP, AIP which are used for the LEDs with spectrum runs from red to green. Gallium nitride (GaN) is used for the LED with spectrum of blue. The reason that the gallium nitride (GaN) emits blue color of light can be speculated by the bandgap voltage. The bandgap voltage of gallium nitride is about 2.7~3.5 eV which is enough to emit light with the spectrum located at around blue or violet region. As known to those of ordinary skill in this art, the aluminum and indium are usually used as the part composition the gallium nitride for blue LEDs. The bandgap voltages of gallium nitride (GaN), aluminum nitride AIN, and indium nitride InN are about 3.5 eV, 6.3 eV, and 2.0 eV, respectively. This means that we can change the bandgap voltage of the nitride compound from 2.0 eV to 6.3 eV such as to get the light with spectrum from red to violet region.

Additionally, U.S. Pat. Nos. 2004/0056258 provides discussions of multi-wavelengths gallium nitride (GaN) LED structure. As mentioned, the prior art provides an embodiment including a sapphire substrate, a gallium nitride (GaN) buffer layer, an undoped gallium nitride (GaN) layer, an Si-doped n-GaN contact layer, a light emtting layer of a multiple quantum well structure (MQW), a p-AlGaN cladding layer, a p-GaN contact layer. The light emitting layer has a multi-layer structure affording at least two peaks in an emission spectrum. The multi-layer structure is a multiple quantum well structure comprising laminates of plural pairs, wherein one pair consists of a well layer and a barrier layer. The laminated pairs are divided into sections corresponding to a number of peak lights desired to generated.

Each section of the quantum well structure has a different band gap. With multiple groups of lighting emitting layers, a light emitting element is able to emit multiple colors. As described in U.S. Pat. Nos. 2004/0056258, the multicolor light emitting element has two peak wavelengths approximately at 575 nm and 475 nm these two wavelengths can mix to emit white light.

Recent work in the field of white led includes the assigned U.S. Pat. No. 5.998.925, for "Light emitting device having a nitride compound semiconductor and a phosphor containing a garnet fluorescent material." The phosphor used in the light emitting diode is excited by visible or ultraviolet ray emitted by the semiconductor light emitting layer. The phosphor is specifically garnet fluorescent material activated with cerium which contains at least one element selected from Y, Lu, Sc, La, Gd and Sm and at least one element selected from Al, Ga and In. The fluorescent material is preferably yttrium-aluminum-garnet fluorescent material (*YAG* phosphor). The LED light emitted by the light emitting component employing the gallium nitride compound semiconductor and the fluorescent light emitted by the phosphor having yellow body color are in the relation of complementary colors, white color can be output by blending the LED light and the fluorescent light. According TW. Pat. Nos. 200525779 provides a method to use dual wavelengths with two kind phosphors, wherein one phosphor absorbs part of violet to produce red peak and the other phophor absorbs part of blue to produce yellow-green peak. The violet, blue, yellow-green and red peaks are further mixed to produce high render index white light. This in turn necessitates the present invention to provide the solutions to improve the performance of such dual wavelengths GaN led structure.

## SUMMARY OF THE INVENTION

It is an object of the present invention to provide a new structure for gallium nitride (GaN) LED in a manner that the emitting efficiency of the gallium nitride (GaN) LED can be improved.

The present invention can be incorporated into a semiconductor structure for light emitting devices that can emit electromagnetic waves of which the frequency can distribute both violet and blue region in the spectrum. The structure, based on a sapphire substrate, comprises a p-type gallium nitride (GaN) layer; a n-type gallium nitride (GaN) layer; an active portion between the p-type gallium nitride layer and n-type gallium nitride layer in the form of multiple $Al_X In_Y Ga_{1-X-Y}N$ barrier layers where $0 < X < 1$ and $0 < Y < 1$ each barrier layer is separated by a $In_x Ga_{1-x}N$ quantum well layer where $0 < X < 1$ for emitting light in the range of the blue and violet spectrum. Additional layer structure referred to the present invention provides improved quantum efficiency of the LED in the spectrum of the violet range. An aluminum gallium indium nitride $Al_{X1} In_{Y1} Ga_{1-X-Y1}N$ layer, where $0 \leq X1 \leq 1$, $0 \leq Y1 \leq 1$ and $X1 + Y1 \leq 1$ corresponding to a higher bandgap level, and an aluminum gallium indium nitride $Al_{X2} In_{Y2} Ga_{1-X2-Y2}N$ layer, where $0 \leq X2 \leq 1$, $0 \leq Y2 \leq 1$ and $X2 + Y2 \leq 1$ corresponding to a lower bandgap level, wherein $X1 > X2$, by providing an energy gap between higher bandgap level and the lower bandgap level, increase the probability of that electrons pass through the barrier layer composed of the $Al_{X1} In_{Y1} Ga_{1-X1-Y1}N$ layer and $Al_{X2} In_{Y2} Ga_{1-X2-Y2}N$ layer obviously.

In an aspect, the invention is a semiconductor structure comprising a strain induce thickness fluctuation layer (SITFL) positioned between the active portion and n-type gallium nitride (GaN) layer; an sapphire substrate at bottom of all layers as a support layer; an undoped gallium nitride (GaN) positioned between the n-type gallium nitride (GaN) layer and the sapphire substrate; a low temperature buffer layer positioned between the undoped gallium nitride (GaN) layer and the sapphire substrate.

In another aspect, the invention is a semiconductor structure comprising a p-type gallium nitride (GaN) layer; a n-type gallium nitride (GaN) layer; an active portion comprising a group of MQW emitting light with a long wavelength, a group of MQW emitting light with a short wavelength and a group of blocking layers; wherein the group of blocking layers is positioned between the p-type gallium nitride layer and n-type gallium nitride layer in the form of multiple $Al_{X3} In_{Y3} Ga_{1-X3-Y3}N$ blocking layers where $0 < X3 < 1$ and $0 < Y3 < 1$ ; wherein the group of MQW, in the form of multiple $Al_X In_Y Ga_{1-X-Y}N$ layers where $0 < X < 1$ and $0 < Y < 1$, emitting light with a short wavelength in the range of the violet spectrum is positioned between the n-type gallium nitride layer and the group of the blocking layers; wherein the group of MQW , in the form of multiple $Al_X In_Y Ga_{1-X-Y}N$ layers where $0 < X < 1$ and $0 < Y < 1$, emitting light with a long wavelength in the range of the blue spectrum is positioned between the p-type gallium nitride layer and the blocking layers;

In another aspect, the invention is a semiconductor structure comprising a strain induce thickness fluctuation layer (SITFL) positioned between the active portion and n-type gallium nitride (GaN) layer; an sapphire substrate at bottom of all layers as a support layer; an undoped gallium nitride (GaN) positioned between the n-type gallium nitride (GaN) layer and the sapphire substrate; a group of blocking layers wherein the group of blocking layers is positioned between the p-type gallium nitride layer and n-type gallium nitride layer in the form of multiple $Al_{X3} In_{Y3} Ga_{1-X3-Y3}N$ blocking layers where $0 < X3 < 1$ and $0 < Y3 < 1$; a low temperature buffer layer positioned between the undoped gallium nitride (GaN) layer and the sapphire substrate.

## BRIEF DESCRIPTION OF THE DRAWINGS

Preferred embodiments of the present invention will now be described, by the way of example only, with reference to the accompanying drawings in which:

FIG. 1 is a cross section of the multi-wavelength light emitting element of the present invention;

FIG. 2 is the bandgap diagram of the MQW with short wavelength of the active region in the prior art;

FIG. 3 is the bandgap diagram of the MQW with short wavelength of the active region in the present invention;

FIG. 4 is another cross section of the multi-wavelength light emitting element of the present invention with the blocking layers;

FIG. 5 is the bandgap diagram of the active region in the present invention with the blocking layers;

FIG. 6 is a spectrum diagram of an example of a wavelength distribution in the present invention; and

FIG. 7 is a spectrum diagram of an example of a wavelength distribution of a high color rendering.

## DETAILED DESCRIPTION OF THE PREFERRED EMBODIMENTS

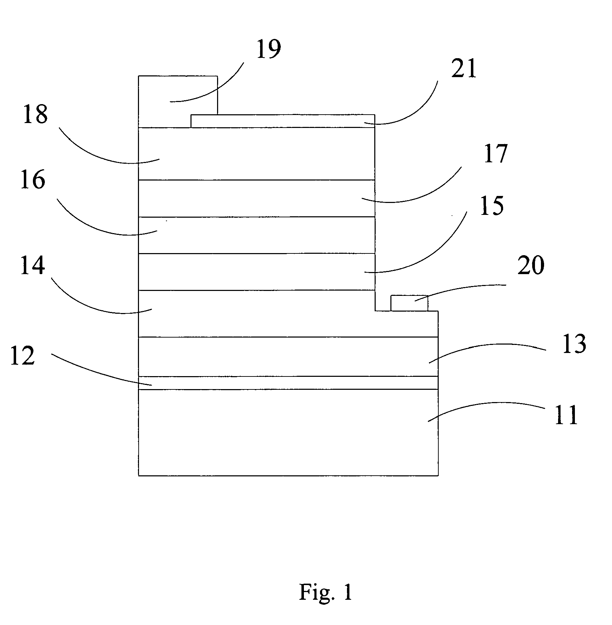

The present invention is a semiconductor structure for light emitting devices that can emit light with multiple wavelengths, in particular, in the green to ultraviolet region of the electromagnetic spectrum. In a first embodiment referred to FIG. 1, the structure comprises an active portion positioned between a p-type gallium nitride (GaN) layer 18 and an n-type gallium nitride (GaN) layer 14. The active portion comprises an MQW 17 emitting light with long wavelength and an MQW 16 emitting light with short wavelength. There is another group of strain induces thickness fluctuation layers (SITFL) 15 positioned between the active portion and the n-type gallium nitride (GaN) layer 14. The semiconductor structure itself is based on a sapphire substrate 11. A low temperature buffer layer 12 is positioned between the sapphire substrate 11 and the n-type gallium nitride (GaN) layer 14. There is still another undoped gallium nitride (GaN) layer 13 positioned between n-type gallium nitride (GaN) layer 14 and the low temperature buffer layer 12. In addition, the SITFL 15 is composed of multiple gallium nitride (GaN) layers doped with silicon (Si) element.

The position of the p-type gallium nitride (GaN) layer 18 can also be exchanged with the n-type gallium nitride (GaN) layer 14 by doping the gallium nitride layers using appropriate concentration of acceptor atoms. The opposite conductivity type can be obtained so that the electrons injected from top to bottom across the p-n junction to recombine with the holes in the p-type gallium nitride (GaN) layers 18. To change the n or p type of a device can be easily reversed by those familiar in the art and will be not be further discussed.

As well known by those having ordinary skill in the art, the active portion may contain Group III compound like aluminum, indium, gallium or any combination of these three elements by changing the molar fraction of them. The layers in the active portion are composed of the compound with the formula $Al_X In_Y Ga_{1-X-Y} N$, where $0 < X < 1$, $0 < Y < 1$ and $X + Y \leq 1$. The Al element can increase the bandgap of the Group III nitride compound and the In element can reduce the bandgap of the Group III nitride compound. Among all the combinations of the Group III compound, the InN has the lowest bandgap voltage and the AlN has the highest bandgap voltage.

FIG. 1 illustrates the cross section of the multi-wavelength light emitting element of the present invention. It is an LED realized with the present invention. This semiconductor structure includes a group of MQW 16, emitting light with short wavelength, comprising multiple quantum wells each divided by a barrier layer comprising of a $Al_{X1} In_{Y1} Ga_{1-X1-Y1} N$ layer, where $0 \leq X1 \leq 1$, $0 \leq Y1 \leq 1$ and $X1 + Y1 \leq 1$, and a $Al_{X2} In_{Y2} Ga_{1-X2-Y2} N$ layer, where $0 \leq X2 \leq 1$, $0 \leq Y2 \leq 1$ and $X2 + Y2 \leq 1$, wherein $X1 > X2$. The $Al_{X1} In_{Y1} Ga_{1-X1-Y1} N$ layer is positioned between the MQW 17 and SITFL 15 and the $Al_{X2} In_{Y2} Ga_{1-X2-Y2} N$ layer is positioned between the $Al_{X1} In_{Y1} Ga_{1-X1-Y1} N$ barrier layer and the SITFL 15. The SITFL layer 15 comprises at least three gallium nitride layers doped with silicon dopants. One gallium nitride layer of the SITFL layer 15 contains higher concentration of silicon dopants is positioned between another gallium nitride of the SITFL layer 15 and the n-type gallium nitride (GaN) layer 14. The third gallium nitride layer of the SITFL layer 15 which has the lowest concentration of silicon dopants is positioned between the group of MQW 16 and another gallium nitride layer doped with silicon dopants. The gallium nitride layer of the SITFL layer 15 with the highest concentration of silicon dopants is preferably about 50 nm to 500 nm thick and is usually preferred to be 100nm. The one with the lowest concentration of silicon dopants is preferably between 10 nm to 300 nm and is most preferably about 50 nm. The one with the concentration between the highest and the lowest is preferably between 5 nm to 300 nm and is preferably about 30 nm. The silicon concentration of the gallium nitride layer of the SITFL layer 15 with the highest concentration of silicon dopants is preferably about $1 \times 10^{18}$ atoms/mole to $5 \times 10^{19}$ atoms/mole and is usually preferred to be $2 \times 10^{19}$ atoms/mole. The one with the lowest concentration of silicon dopants is preferably between $1 \times 10^{16}$ atoms/mole to $1 \times 10^{17}$ atoms/mole and is most preferably about $5 \times 10^{16}$ atoms/mole. The one with the concentration between the highest and the lowest is preferably between $5 \times 10^{16}$ atoms/mole to $2 \times 10^{19}$ atoms/mole and is preferably about $6 \times 10^{17}$ atoms/mole. The SITFL layer 15 provides the strain modulation between the n-type gallium nitride 14 and MQW active layer, by the strain modulation it can provide the more rough surface before growing MQW, so it can induce the thickness distribution fluctuaction during well and barrier layers This increases the carrier localization efficiency of the MQW active layer by providing SITFL An ohmic contact 19 and a transparent contact layer (TCL) 21 are positioned in contact with p-type gallium nitride layer 18 to supply the positive voltage. An ohmic contact 20 is positioned in contact with n-type gallium nitride layer 14 to supply the negative voltage.

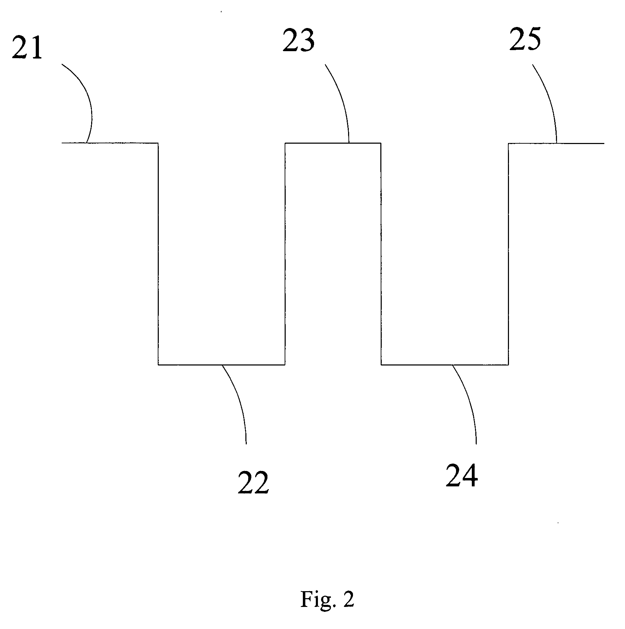

FIG. 2 is the bandgap diagram of the MQW 16 with short wavelength of the active region in the prior art. The LED emitting light within blue region of the spectrum in the prior art comprises a p-type gallium nitride layer corresponding to the bandgap level 21, an indium gallium nitride (InGaN) layer corresponding to the bandgap level 22, an aluminum gallium nitride (AlGaN) corresponding to the bandgap level 23, an indium gallium nitride (InGaN) layer corresponding to the bandgap level 24, and a n-type gallium nitride (GaN) layer 25. The bandgap level 22 and bandgap level 24 play the roles as quantum wells, a place where the electrons combine with the holes and emit the light in a specific region of spectrum. It is often that the quantum efficiency of LEDs emitting light in the region of the spectrum from blue to violet is very inefficient. A semiconductor device structure is provided in the present invention to improve the quantum efficiency of LEDs, in particular, in both blue and violet spectrum.

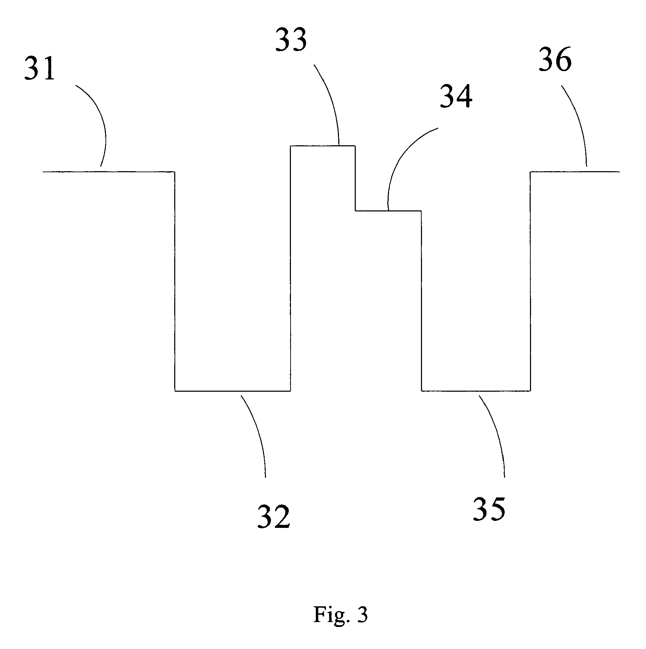

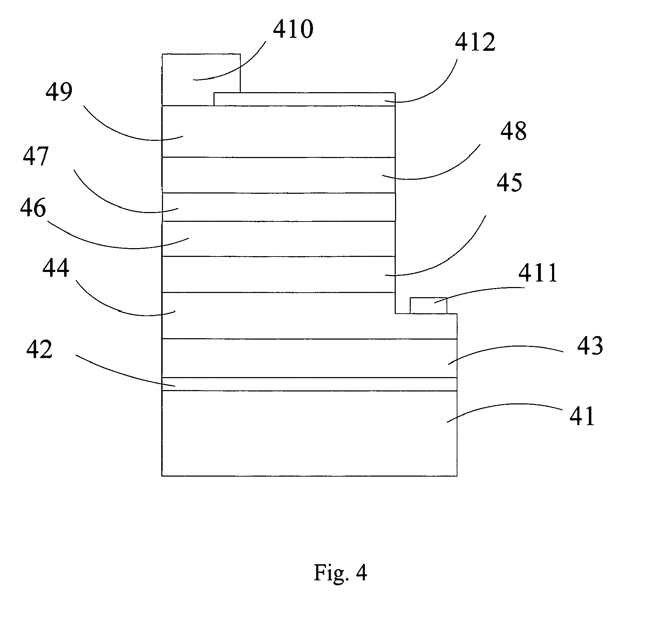

FIG. 3 is the bandgap diagram of the MQW 16 with short wavelength of the active region in the present invention. The semiconductor structure in the present invention comprises a p-type gallium nitride layer corresponding to the bandgap level 31, an indium gallium nitride (InGaN) layer corresponding to the bandgap level 32, an aluminum gallium indium nitride $Al_{X1} In_{Y1} Ga_{1-X1-Y1} N$ layer, where $0 \leq X1 \leq 1$, $0 \leq Y1 \leq 1$ and $X1 + Y1 \leq 1$ corresponding to the bandgap level 33, an aluminum gallium indium nitride $Al_{X2} In_{Y2} Ga_{1-X2-Y2} N$ layer, where $0 \leq X2 \leq 1$, $0 \leq Y2 \leq 1$ and $X2 + Y2 \leq 1$, wherein $X1 > X2$ corresponding to the bandgap level 34, an indium gallium nitride (InGaN) layer corresponding to the bandgap level 35, and a n-type gallium nitride (GaN) layer 36. The bandgap level 32 and bandgap level 35 play the roles as quantum wells, a place where the electrons combine with the holes and emit the light in a specific region of the spectrum. By providing an energy gap between bandgap level 33 and bandgap level 34, the probability of that electrons pass through the bandgap level 33 and bandgap level 34 is increased obviously. The quantum efficiency of the LED in the spectrum of the violet range is improved. Furthermore, FIG. 4 is another cross section of the multi-wavelength light emitting element of the present invention with the blocking layers 47. It is an LED realized with the present invention with additional blocking layers 47. This semiconductor structure includes a group of MQW 46, emitting light with short wavelength, comprising multiple quantum wells each divided by a barrier layer comprising a $Al_{X1}In_{Y1}Ga_{1-X1-Y1}N$ layer, where $0 \leq X1 \leq 1$, $0 \leq Y1 \leq 1$ and $X1 + Y1 \leq 1$, and a $Al_{X2}In_{Y2}Ga_{1-X2-Y2}N$ layer, where $0 \leq X2 \leq 1$, $0 \leq Y2 \leq 1$ and $X2 + Y2 \leq 1$, wherein $X1 > X2$. The $Al_{X1}In_{Y1}Ga_{1-X1-Y1}N$ layer is positioned between the blocking layers 47 and $Al_{X2}In_{Y2}Ga_{1-X2-Y2}N$ where the $Al_{X2}In_{Y2}Ga_{1-X2-Y2}N$ layer is positioned between the $Al_{X1}In_{Y1}Ga_{1-X1-Y1}N$ layer and the SIFEL layer 45. The SITFL layer 45 comprises at least three gallium nitride layers doped with silicon dopants. One gallium nitride layer of the SIFEL layer 45 contains higher concentration of silicon dopants is positioned between another gallium nitride of the SIFEL layer 45 and the n-type gallium nitride (GaN) layer 44. The third gallium nitride layer of the SIFEL layer 45 which has the lowest concentration of silicon dopants is positioned between the group of MQW 46 and another gallium nitride layer doped with silicon dopants. The blocking layer 47 positioned between the group of MQW 48 and the group of MQW 46 is made of $Al_{X3}In_{Y3}Ga_{1-X3-Y3}N$ where $0 \leq X3 \leq 1$, $0 \leq Y3 \leq 1$ and $X3 + Y3 \leq 1$, wherein $X3 > X1 > X2$. An ohmic contact 410 and a transparent contact layer (TCL) 412 are positioned in contact with p-type gallium nitride layer 49 to supply the positive voltage. An ohmic contact 411 is positioned in contact with n-type gallium nitride layer 44 to supply the negative voltage.

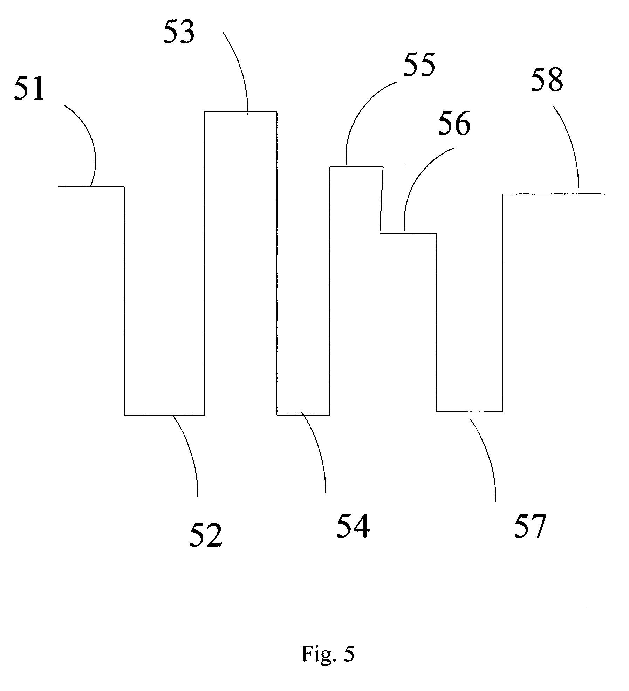

FIG. 5 is the bandgap diagram of the active region in the present invention with the blocking layers 47. The semiconductor structure in the present invention with blocking layers 47 comprises a p-type gallium nitride layer corresponding to the bandgap level 51, an indium gallium nitride InGaN layer corresponding to the bandgap level 52, an single or multiple of blocking layers corresponding to the bandgap level 53, a quantum well layer corresponding to a bandgap level 54, an aluminum gallium nitride $Al_{X1}In_{Y1}Ga_{1-X1-Y1}N$ layer, where $0 \leq X1 \leq 1$, $0 \leq Y1 \leq 1$ and $X1 + Y1 \leq 1$ corresponding to the bandgap level 55, an aluminum gallium nitride $Al_{X2}In_{Y2}Ga_{1-X2-Y2}N$ layer, where $0 \leq X2 \leq 1$, $0 \leq Y2 \leq 1$ and $X2 + Y2 \leq 1$, wherein $X1 > X2$ corresponding to the bandgap level 56, an indium gallium nitride InGaN layer corresponding to the bandgap level 57, and a n-type gallium nitride (GaN) layer 58. The bandgap level 52, bandgap level 54 and bandgap level 57 play the roles as quantum wells, a place where the electrons combine with the holes and emit the light in a specific region of the spectrum. By providing an energy gap between bandgap level 55 and bandgap level 56, the energy of the carriers are increased before passing through the group of MQW 46. The carriers cannot return to the group of MQW 48 due to the higher barrier built by the bandgap level 53. The concentration of the carriers in the quantum well corresponding to the bandgap level 54 increases. The quantum efficiency of the LED in the spectrum of the violet range is improved, too.

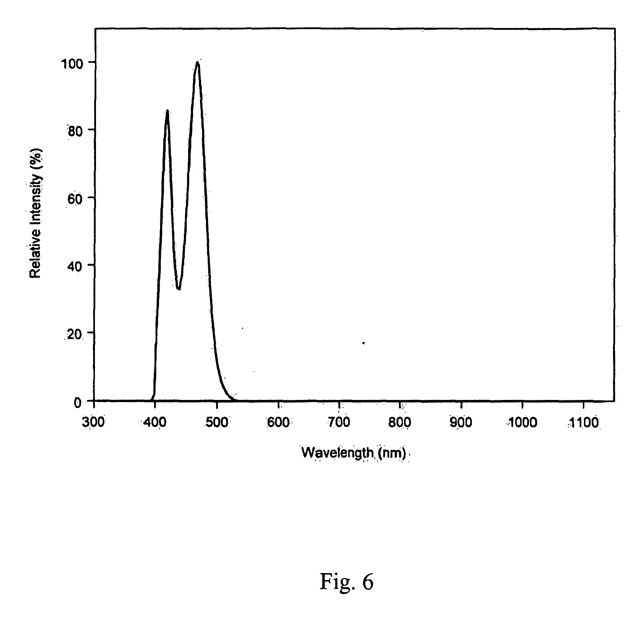

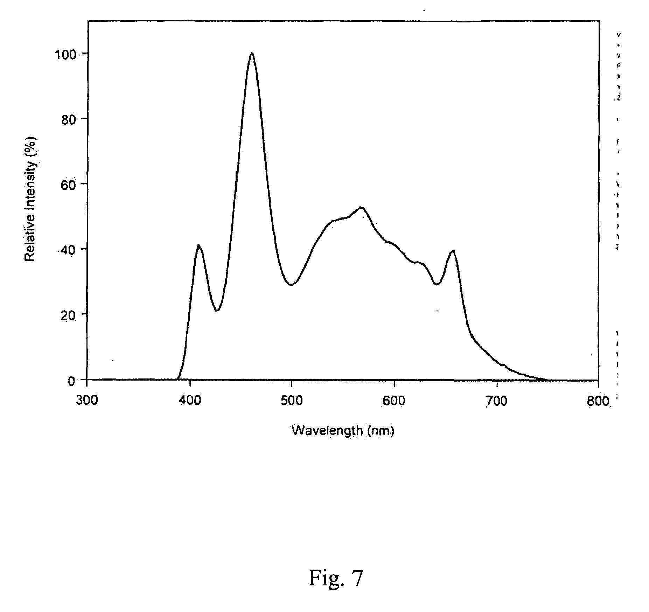

FIG. 6 shows a spectrum diagram of an example of a wavelength distribution in the present invention. In the diagram, the gallium nitride semiconductor light emitting device also has two peak wavelengths as similar as U.S. Pat. Nos. 2004/0056258. FIG. 7 shows a spectrum diagram of an example of a wavelength distribution of a high color rendering. In the diagram, the wavelength range for the high color rendering is regarding a white light source.

The features disclosed in the foregoing description, in the claims and/or in the accompanying drawings may, both separately and in any combination thereof, be material for realising the invention in diverse forms thereof.

## Claims

1. A semiconductor light emitting layer structure for light emitting devices, comprising:

    an n-type gallium nitride (GaN) layer;
    a p-type gallium nitride (GaN) layer;
    a first group of multiple quantum wells (MQW), emitting light with long wavelength between said n-type gallium nitride (GaN) layer and said p-type gallium nitride (GaN) layer; and
    a second group of MQW, composed by a plurality of quantum wells each divided by a barrier layer comprising a $Al_{X1}In_{Y1}Ga_{1-X1-Y1}N$ layer, where $0 \leq X1 \leq 1$, $0 \leq Y1 \leq 1$ and $X1 + Y1 \leq 1$, and a $Al_{X2}In_{Y2}Ga_{1-X2-Y2}N$ layer, where $0 \leq X2 \leq 1$, $0 \leq Y2 \leq 1$ and $X2 + Y2 \leq 1$, wherein $X1 > X2$, emitting light with short wavelength between said first group of MQW and said n-type gallium nitride (GaN) layer.

2. The structure according to claim 1, further including a SITFL structure comprising at least a first silicon doped gallium nitride layer in contact with said n-type gallium nitride layer, a second silicon doped gallium nitride layer positioned between said first silicon doped gallium nitride layer and a third silicon doped gallium nitride layer, and said third silicon doped gallium nitride layer in contact with said second group of MQW.

3. The structure according to claim 2, wherein the silicon concentration of said first silicon doped gallium nitride layer is greater than that of said second silicon doped gallium nitride layer and the silicon concentration of said second silicon doped gallium nitride layer is greater than that of said third silicon doped gallium nitride layer.

4. The structure according to claim 2, wherein the thickness of said first silicon doped gallium nitride layer is greater than that of said second silicon doped gallium nitride layer and the thickness of said second silicon doped gallium nitride layer is greater than that of said third silicon doped gallium nitride layer

5. The structure according to claim 1, wherein the long wavelength is in the spectrum of blue.

6. The structure according to claim 1, wherein the short wavelength is in the spectrum of violet.

7. A semiconductor structure for light emitting devices, comprising:

an n-type gallium nitride (GaN) layer;
a p-type gallium nitride (GaN) layer;
a first group of MQW, emitting light with long wavelength between said n-type gallium nitride (GaN) layer and said p-type gallium nitride (GaN) layer;
a second group of MQW, which comprising multiple quantum wells each divided by a barrier layer comprising a $Al_{X1}In_{Y1}Ga_{1-X1-Y1}N$ layer, where $0 \leq X1 \leq 1$, $0 \leq Y1 \leq 1$ and $X1 + Y1 \leq 1$, and a $Al_{X2}In_{Y2}Ga_{1-X2-Y2}N$ layer, where $0 \leq X2 \leq 1$, $0 \leq Y2 \leq 1$ and $X2 + Y2 \leq 1$, wherein $X1 > X2$, emitting light with short wavelength between said first group of MQW and said n-type gallium nitride (GaN) layer; and
a blocking portion in the form of at least one blocking layer positioned between the first group of MQW and the second group of MQW.

8. The structure according to claim 7, further including a SITFL structure comprising at least a first silicon doped gallium nitride layer in contact with said n-type gallium nitride layer, a second silicon doped gallium nitride layer positioned between said first silicon doped gallium nitride layer and a third silicon doped gallium nitride layer, and said third silicon doped gallium nitride layer in contact with said second group of MQW.

9. The structure according to claim 8, wherein the silicon concentration of said first silicon doped gallium nitride layer is greater than that of said second silicon doped gallium nitride layer and the silicon concentration of said second silicon doped gallium nitride layer is greater than that of said third silicon doped gallium nitride layer.

10. The structure according to claim 8, wherein the thickness of said first silicon doped gallium nitride layer is greater than that of said second silicon doped gallium nitride layer and the thickness of said second silicon doped gallium nitride layer is greater than that of said third silicon doped gallium nitride layer.

11. The structure according to claim 7, wherein said blocking layer is positioned between said first group of MQW and said second group of MQW and is made of $Al_{X3}In_{Y3}Ga_{1-X3-Y3}N$ where $0 \leq X3 \leq 1$, $0 \leq Y3 \leq 1$ and $X3 + Y3 \leq 1$, wherein $X3 > X1 > X2$.

12. The structure according to claim 7, wherein the long wavelength is in the spectrum of blue.

13. The structure according to claim 7, wherein the short wavelength is in the spectrum of violet.

Fig. 1

21    23    25

22    24

Fig. 2

31

33

36

34

32

35

Fig. 3

Fig. 4

Fig. 5

Fig. 6

Fig. 7

**European Patent Office**

**EUROPEAN SEARCH REPORT**

Application Number

EP 05 02 0082

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CHEN ET AL: "InGaN/GaN MQW dual-wavelength near-white LEDs" PHYSICA STATUS SOLIDI C, no. 7, 2003, pages 2257-2260, XP008060377 ISSN: 1610-1634 * page 2257 - page 2258 * | 1-13 | H01L33/00 H01S5/343 |
| D,X | US 2004/056258 A1 (TADATOMO K ET AL) 25 March 2004 (2004-03-25) * paragraphs [0014] - [0041] * | 1-13 | |
| X | OZDEN ET AL: "Dual-wavelength InGaN LED" APPLIED PHYSICS LETTERS, vol. 79, 15 October 2001 (2001-10-15), pages 2532-2534, XP001103332 ISSN: 0003-6951 * page 2532 - page 2533, column 1 * | 1-13 | |
| A | EP 1 248 303 A (NICHIA CORPORATION) 9 October 2002 (2002-10-09) * paragraphs [0091] - [0098] * | 1 | |
| A | US 6 849 881 B1 (HARLE VOLKER ET AL) 1 February 2005 (2005-02-01) * column 3, line 45 - column 4, line 6 * * column 5, lines 16-29 * | 1,7 | TECHNICAL FIELDS SEARCHED (IPC) H01L |
| A | EP 1 313 187 A (NICHIA CORPORATION) 21 May 2003 (2003-05-21) * column 13, lines 33-54; example 13 * | 1,7 | |
| A | EP 1 453 160 A (NICHIA CORPORATION) 1 September 2004 (2004-09-01) * paragraph [0058] * | 1,7 | |
| A | CN 1 658 454 A (SUMITOMO ELECTRIC IND) 24 August 2005 (2005-08-24) * page 20, line 27 - page 25, line 26 * | 1 | |

-/--

The present search report has been drawn up for all claims

| Place of search | Date of completion of the search | Examiner |
|---|---|---|
| The Hague | 21 February 2006 | van der Linden, J.E. |

EPO FORM 1503 03.82 (P04C01)

**European Patent Office**

**EUROPEAN SEARCH REPORT**

Application Number

EP 05 02 0082

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | & EP 1 598 909 A (SUMITOMO ELECTRIC IND) 23 November 2005 (2005-11-23) * paragraphs [0089] - [0094], [0110] * | 1 | |
| A | US 2004/206949 A1 (BOUR D ET AL) 21 October 2004 (2004-10-21) * paragraphs [0076] - [0079] * | 1 | |
| A | NEE T ET AL: "Cross sections for the investigation of EL excitation of InGaN/GaN LEDs with MQB" J. VAC. SCI. TECHNOL. B, vol. 23, May 2005 (2005-05), pages 966-969, XP008060260 ISSN: 1071-1023 * the whole document * | 1 | |

TECHNICAL FIELDS SEARCHED (IPC)

The present search report has been drawn up for all claims

| Place of search | Date of completion of the search | Examiner |
|---|---|---|
| The Hague | 21 February 2006 | van der Linden, J.E. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 05 02 0082

This annex lists the patent family members relating to the patent documents cited in the above-mentioned European search report.
The members are as contained in the European Patent Office EDP file on
The European Patent Office is in no way liable for these particulars which are merely given for the purpose of information.

21-02-2006

| Patent document cited in search report | | Publication date | Patent family member(s) | | Publication date |
|---|---|---|---|---|---|
| US 2004056258 | A1 | 25-03-2004 | WO | 0249121 A1 | 20-06-2002 |
| | | | JP | 2002176198 A | 21-06-2002 |
| EP 1248303 | A | 09-10-2002 | AU | 772491 B2 | 29-04-2004 |
| | | | AU | 1736701 A | 18-06-2001 |
| | | | CA | 2394460 A1 | 14-06-2001 |
| | | | CN | 1409875 A | 09-04-2003 |
| | | | HK | 1054467 A1 | 08-04-2005 |
| | | | WO | 0143206 A1 | 14-06-2001 |
| | | | JP | 2001237457 A | 31-08-2001 |
| | | | TW | 498582 B | 11-08-2002 |
| | | | US | 2002179923 A1 | 05-12-2002 |
| US 6849881 | B1 | 01-02-2005 | CA | 2360502 A1 | 31-05-2001 |
| | | | WO | 0139282 A2 | 31-05-2001 |
| | | | DE | 19955747 A1 | 23-05-2001 |
| | | | EP | 1145331 A2 | 17-10-2001 |
| | | | JP | 2003515936 T | 07-05-2003 |
| | | | TW | 479374 B | 11-03-2002 |
| | | | US | 2005116216 A1 | 02-06-2005 |
| EP 1313187 | A | 21-05-2003 | AU | 6945901 A | 21-01-2002 |
| | | | CA | 2415056 A1 | 30-12-2002 |
| | | | CN | 1440579 A | 03-09-2003 |
| | | | WO | 0205399 A1 | 17-01-2002 |
| | | | TW | 587355 B | 11-05-2004 |
| | | | US | 2002053676 A1 | 09-05-2002 |
| EP 1453160 | A | 01-09-2004 | CN | 1484880 A | 24-03-2004 |
| | | | WO | 03041234 A1 | 15-05-2003 |
| | | | US | 2005127391 A1 | 16-06-2005 |
| CN 1658454 | A | 24-08-2005 | EP | 1598909 A2 | 23-11-2005 |
| | | | JP | 2005268743 A | 29-09-2005 |
| | | | US | 2005199903 A1 | 15-09-2005 |
| EP 1598909 | A | 23-11-2005 | CN | 1658454 A | 24-08-2005 |
| | | | JP | 2005268743 A | 29-09-2005 |
| | | | US | 2005199903 A1 | 15-09-2005 |
| US 2004206949 | A1 | 21-10-2004 | JP | 2004320038 A | 11-11-2004 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20040056258 A
- US 5998925 A

- TW 200525779